# EUROPÄISCHE PATENTANMELDUNG

(11) **EP 1 722 475 A1**
(43) Veröffentlichungstag der Anmeldung: **15.11.2006**
(21) Anmeldenummer: 06009733.4
(22) Anmeldetag: 11.05.2006
(51) Int. Cl.: H03J 1/00, H04H 1/00

(54) **Vermeidung von Mehrfach-Einträgen in einer Programmliste eines DVB-T-Empfängers und Programmdiversity**

(30) Priorität: 11.05.2005 DE 102005021752
(71) Anmelder: Hirschmann Car Communication GmbH, 72654 Neckartenzlingen (DE)
(72) Erfinder: Armbrüster, Michael, 72636 Frickenhausen (DE); Schwarz, Christian, 72658 Bempflingen (DE)
(74) Vertreter: Thul, Hermann

(57) **Zusammenfassung**

Die Erfindung betrifft ein Verfahren zum Empfangen von Rundfunk- oder Fernsehprogrammen sowie zum Anzeigen der empfangenen Programme in einer Programmliste, wobei erfindungsgemäß vorgesehen ist, dass für den Fall, das ein und dasselbe Programm mehrfach empfangen wird, dieses Programm nur einmal in der Programmliste dargestellt wird.

## Beschreibung

Die Erfindung betrifft ein Verfahren zum Empfangen von Rundfunk- oder Fernsehprogrammen sowie zum Anzeigen der empfangenen Programme in einer Programmliste gemäß den Merkmalen des Oberbegriffes des Patentanspruches 1.

Beim Empfangen von Rundfunk- und/oder Fernsehprogrammen, die auf geeigneten Wiedergabegeräten akustisch und/oder optisch wiedergegeben werden, ist es gängige Praxis, dass dasselbe Programm oftmals von verschiedenen Senderstandorten aus auf verschiedenen Frequenzen abgestrahlt wird. Dies ist oftmals dann der Fall, wenn Programme in Fahrzeugen, die sich auf einer Straße bewegen, empfangen werden. Die entsprechende stationäre oder mobile Empfangseinrichtung führt in an sich bekannter Weise einen Programmsuchlauf durch, bei dem ein entsprechender ausgebildeter Empfänger nach Frequenz sucht, auf denen ein Programm zu empfangen ist, welches von einer Bedienperson gehört oder gesehen werden will. Bei dem von dem Empfänger durchgeführten Programmsuchlauf, der mit nur einer Antenne oder auch mehreren Antennen (Diversity) durchgeführt werden kann, kann diese Mehrfachabstrahlung von Programmen auf unterschiedlichen Frequenzen dazu führen, das ein und dasselbe Programm mehrfach in einer Programmliste erscheint. Diese Programmliste wird von der Empfangseinrichtung angelegt, um eine Bedienperson anzuzeigen, welches Rundfunk- und/oder Fernsehprogramme, egal ob Analog oder Digital empfangen, gehört bzw. gesehen werden können. Da die Bedienperson (der Konsument) keinen nutzen davon hat, das ein und dasselbe Programm mehrfach in der Programmliste erscheint (insbesondere ohne weitere Angaben über die Qualität des empfangenen Programmes) wird die Programmliste nur unnötig groß. Dies führt zu einer Unübersichtlichkeit der zu empfangenen Programme bei der Anzeige in der Programmliste, was insbesondere beim Einsatz in Fahrzeugen von besonderem Nachteil ist, da ein Fahrer des Fahrzeugs hiervon abgelenkt wird.

Der Erfindung liegt daher die Aufgabe zugrunde, ein Verfahren zum Empfangen von Rundfunk- und/oder Fernsehprogrammen sowie zum Anzeigen der empfangenen Programme in einer Programmliste so zu verbessern, das Mehrfacheinträge ein und desselben Programmes in der Programmliste unterdrückt bzw. vermieden werden.

Diese Aufgabe ist durch die Merkmale des Patentanspruches 1 gelöst.

Erfindungsgemäß ist vorgesehen, dass für den Fall, das ein und dasselbe Programm mehrfach empfangen wird, dieses Programm nur einmal in der Programmliste dargestellt wird. Damit werden Mehrfacheinträge in der Programmliste unterdrückt, so dass diese Programmliste jedes empfangene Programm nur ein einziges Mal anzeigt, was die Übersichtlichkeit und Erkennbarkeit der zu empfangenen Programme wesentlich verbessert. Für den Fall, dass ein und dasselbe Programm nur einfach empfangen wird, erfolgt auch nur dieser eine Eintrag ein der Programmliste.

In Weiterbildung der Erfindung werden die Frequenzen dieses Programmes, die Empfangen werden, abgespeichert. Dies hat den Vorteil, das ein Programm, dass von unterschiedlichen Senderstandorten, abgestrahlt wird und auf unterschiedlichen Frequenzen von der Empfangseinrichtung empfangen werden kann, nur einmal in der Programmliste erscheint, aber die Frequenzen trotzdem abgespeichert werden, um beispielsweise bei Änderungen, vor allen Dingen Verschlechterungen in der Empfangsqualität auf eine andere Frequenz des gleichen Programmes umschalten zu können. Hierzu weist die Empfangseinrichtung entsprechende Speichereinheiten auf, in der die Frequenzen der jeweils empfangenen Programme abgespeichert und wieder aufgerufen werden können. Die Kriterien, anhand derer bewertet wird, wann von der einen Frequenz auf eine andere empfangbare Frequenz umgeschaltet werden muss, sind nicht Bestandteil der Erfindung, so dass sich entsprechende Ausführungen hierzu erübrigen. Als Beispiel für ein solches Kriterium, wann von der einen auf eine andere Frequenz umgeschaltet werden kann, sei der Pegel der Signale genannt.

In Weiterbildung der Erfindung werden die Frequenzen des empfangenen Programmes bewertet und anhand vorgebbarer Bewertungskriterien entschieden, welche Frequenz bzw. welcher zugehörige Programmname oder Programminhalt in der Programmliste angezeigt und/oder wiedergegeben wird. Dies hat den Vorteil, das jeweils das jenige Empfangssignal (Frequenz) für die Darstellung des gewählten Programms in der Programmliste bzw. für die Wiedergabe dieses Programmes genutzt werden kann, welches zur Darstellungszeit den besten Empfang ermöglicht. Dabei ist es nicht entscheidend, welche Empfangsqualität während des Programmsuchlaufes herrschte. Es ist beim Programmsuchlauf lediglich eine Mindestqualität der Signale notwendig, damit das zu empfangene Programm (zum Beispiel anhand der Frequenz der empfangenen Signale, der Inhalte der Signale wie zum Beispiel RDS-ldentifizierungen und dergleichen) identifiziert werden kann. Weiterhin müssen alle während eines Programmsuchlaufes gefundenen Alternativfrequenzen in einem Speicher abgelegt und später aufgerufen werden können. Sollte sich die Empfangsverhältnisse z.B. durch Bewegung des Empfängers (untergebracht in einem Fahrzeug) ändern, kann durch insbesondere automatische Umschaltung auf eine Alternativfrequenz, die aus dem Speicher abgerufen wird, eine Empfangsverbesserung und damit eine verbesserte Wiedergabe von Rundfunksignalen bzw. Fernsehsignalen erzielt werden.

In Weiterbildung der Erfindung sind ein vorgebbares Bewertungskriterium die PSI- oder SI-Daten des Programmes. Zur Unterdrückung von Mehrfacheinträgen ind er Programmliste werden also PSI- und/oder SI-Daten des Programmes herangezogen, welche ein Programm eindeutig kennzeichnen. Alternativ oder ergänzend zu diesen Daten sind selbstverständlich auch weitere Daten für die Bewertung und Unterdrückung von Mehrfacheinträgen anwendbar. Hierzu weist die Empfangseinrichtung entsprechende Mittel auf, welche diese Daten aus den empfangenen Signalen herausfiltern. Bei diesem Mittel handelt sich beispielsweise um Filtereinrichtungen wie section filter und dergleichen.

In vorteilhafter Weiterbildung der Erfindung wird das Programm mit der besten Empfangsqualität in der Programmliste angezeigt und auch wiedergegeben. Daneben ist es selbstverständlich auch möglich, zwar das empfangene Programm mit der besten Empfangsqualität wiederzugeben, daneben aber das gleiche Programm, welches auf einer anderen Frequenz abgestrahlt wird und welches eine schlechtere Signalqualität aufweist, in die Programmliste einzutragen. Hierbei kann auch noch daran gedacht werden, die Empfangsqualität in geeigneter Weise der Bedienperson anzuzeigen.

Eine weitere Ausgestaltung der Erfindung ist gekennzeichnet durch das Verfahren und seine Anwendung in Empfangssystemen in Fahrzeugen. Hier ist die Unterdrückung von Mehrfacheintragungen in der Programmliste besonders erforderlich, damit die Übersichtlichkeit der dem Fahrer angezeigten Programmliste gewährleistet ist und er durch einen Blick auf die Programmliste und die anschließende Auswahl von Programmen von Mehrfacheinträgen nicht abgelenkt wird.

Eine beispielhafte Vorrichtung zur Durchführung des erfindungsgemäßen Verfahrens ist gekennzeichnet durch zumindest einen Empfangszug, der zumindest eine Antenne zum Empfangen von hochfrequenten Signalen aufweist. Dabei kann der Empfangszug zum Empfangen und Verarbeiten von analogen und/oder digitalen Signalen ausgebildet sein. Es ist nur wichtig, dass der Empfangszug, insbesondere dessen Empfänger darauf abgestimmt ist, Signale bestimmter Art (Analog oder Digital) und in bestimmten Frequenzbereichen zu empfangen und weiterzuverarbeiten. Diese Signale können von stationären oder mobilen Sendern oder auch von Satelliten oder in sonstiger Weise abgestrahlt werden. Der Antenne bzw. den Antennen ist bzw. sind ein oder mehrere Empfänger, Verstärker, Demodulatoren oder dergleichen nachgeschaltet, je nachdem welche Art von Signalen bzw. Frequenzen empfangen werden sollen. Weiterhin ist der Empfangszug so ausgebildet, dass die empfangenen hochfrequenten Signale zur akustischen und/oder optischen Wiedergabe aufbereitet werden. Gleichzeitig weist der Empfangszug bzw. die gesamte Empfangseinrichtung als Bestandteil Mittel zur Erzeugung und Anzeige einer Programmliste auf, in der die empfangenen Programme bzw. deren Namen angezeigt werden können.

Bezüglich des gesamten Empfangssystems ist noch darauf hinzuweisen, dass es dazu ausgebildet sein kann (aber nicht muss), bei dem Signalempfang und der Signalverarbeitung einen Übergang von Empfangsgebieten mit analogen Signalen in ein Empfangsgebieten mit digitalen Empfangssignalen (insbesondere in ein DVB-T Gebiet) zu ermöglichen. Dies soll automatisch erfolgen, ohne dass eine Bedienperson (Konsument) einen Umschaltvorgang an dem Empfänger auslösen muss. Hierfür ist vorgesehen, dass die PSI- und/oder SI-Daten (oder andere Daten oder eine Kombination aus diesen) des DVB-T-Signals oder eines anderen digitalen Signals, welche auf jeden Fall das Programm eindeutig kennzeichnen, für die Umschaltung herangezogen werden. Hierfür weist dann die gesamte Empfangseinrichtung eine Bewertungseinheit für die Signalqualität sowohl des analogen als auch des digitalen, insbesondere des DVB-T -Empfangssignals, auf. Aus dem für das gewünschte Programm im Empfänger abgelegten Vorrat an Empfangswegen (beispielsweise analog mehrere Frequenzen, digital mehrere Frequenzen und dergleichen) wird jeweils der Empfangsweg (Empfangszug) mit der besten Qualität für die Wiedergabe des Programms und die Eintragung des Programmes in der Programmliste herangezogen.

SI ist die Abkürzung für Service Information, PSI die Abkürzung für Programm-Spezifische-Information.

## Patentansprüche

**1.** Verfahren zum Empfangen von Rundfunk- oder Fernsehprogrammen sowie zum Anzeigen der empfangenen Programme in einer Programmliste, **dadurch gekennzeichnet, dass** für den Fall, das ein und dasselbe Programm mehrfach empfangen wird, dieses Programm nur einmal in der Programmliste dargestellt wird.

**2.** Verfahren nach Anspruch 1, **dadurch gekennzeichnet, dass** die Frequenzen dieses Programmes, die empfangen werden, abgespeichert werden.

**3.** Verfahren nach Anspruch 1 oder 2, **dadurch gekennzeichnet, dass** die Frequenzen dieses Programmes bewertet werden und anhand vorgebbarer Bewertungskriterien entschieden wird, welche Frequenz bzw. welcher zugehöriger Programmname oder Programminhalt in der Programmliste angezeigt und/oder wiedergegeben wird.

**4.** Verfahren nach Anspruch 3, **dadurch gekennzeichnet, dass** ein vorgebbares Bewertungskriterium die PSI- und/ oder SI-Daten des Programmes sind.

**4.** Verfahren nach einem der vorhergehenden Ansprüche, **dadurch gekennzeichnet, dass** dieses Programm mit der besten Empfangsqualität in der Programmliste angezeigt wird.

**5.** Verfahren nach einem der vorhergehenden Ansprüche, **gekennzeichnet durch** seine Anwendung in Empfangssystemen in Fahrzeugen.

**6.** Verfahren nach einem der vorhergehenden Ansprüche, **gekennzeichnet durch** die Verarbeitung von analogen und/oder digitalen Signalen.

**7.** Verfahren nach Anspruch 6, **dadurch gekennzeichnet, dass** die digitalen Signale DVB-T-Signale sind.
